# EUROPEAN PATENT APPLICATION

(11) **EP 4 712 719 A2**
(43) Date of publication of application: **18.03.2026**
(21) Application number: 25198380.5
(22) Date of filing: 27.08.2025
(51) Int. Cl.: H10B 12/00

(54) **SYSTEM AND METHODS FOR AN U-SHAPED VERTICAL ELECTRODE**

(30) Priority: 16.09.2024 US 202463695334 P; 12.05.2025 US 202519206027
(71) Applicant: SAMSUNG ELECTRONICS CO., LTD., Yeongtong-gu Suwon-si, Gyeonggi-do 16677 (KR)
(72) Inventor: PARK, Sohyun, San Jose, CA, 95134 (US); KIM, Dongwan, San Jose, CA, 95134 (US); KIM, Byeung Chul, San Jose, CA, 95134 (US)
(74) Representative: Kuhnen & Wacker Patent- und Rechtsanwaltsbüro PartG mbB

(57) **Abstract**

Disclosed herein are methods, devices and systems including a first electrode (104), the first electrode (104) having a first electrode segment (111), a second electrode segment (109), and a third electrode segment (113). The first electrode segment (111) may be coupled to the second electrode segment (109), and the second electrode segment (109) may be coupled to the third electrode segment (113). A second electrode (114) may extend parallel to the first electrode (104). A first dielectric material (106) may be between the first electrode (104) and the second electrode (114), and a second dielectric material (108) may be between the first electrode segment (111) and the third electrode segment (113). A third electrode (116) may contact the first electrode (104), and the third electrode (116) may extend in a direction orthogonal to the first electrode (104). The first electrode segment (111) may extend parallel to the third electrode segment (113).

## Description

### TECHNICAL FIELD

The subject matter disclosed herein relates to microelectronics and integrated circuits (IC) structures. More particularly, the subject matter disclosed herein relates to a semiconductor structure involving an electrode having a three-dimensional shape.

### BACKGROUND

Semiconductor devices may be created using complex three-dimensional structures made up of sets of smaller components. Such components may include circuit components, such as transistors, capacitors, etc., reproduced in large numbers and addressed using a matrix of intersecting lines. However, forming an address matrix can be complex and may face difficulties in forming conductive lines and/or ensuring sufficient isolation between individual lines. It is further noted that background concepts discussed herein are for informational purposes only and are not intended to limit the present disclosure, nor should the background or field described be intended to limit the disclosure herein to a particular use or concept.

### SUMMARY

An example embodiment provides a device including a first electrode, the first electrode having a first electrode segment, a second electrode segment, and a third electrode segment. The first electrode segment may be coupled to the second electrode segment, and the second electrode segment may be coupled to the third electrode segment. A second electrode may extend parallel to the first electrode. A first dielectric material may be between the first electrode and the second electrode, and the second dielectric material may be between the first electrode segment and the third electrode segment. A third electrode may contact the first electrode, and the third electrode may extend in a direction orthogonal to the first electrode. The first electrode segment may extend parallel to the third electrode segment. The first dielectric material may include one or more of a carbide, nitride and oxide. The second dielectric material may include one or more of a carbide, nitride and oxide. The first dielectric material may differ from the second dielectric material. The first electrode may form a vertical bit line electrode and the third electrode may form a cell electrode. The first dielectric material may extend in a direction parallel to the first electrode, and the second dielectric material may extend in a direction parallel to the first electrode. The second electrode may include a fourth electrode segment, a fifth electrode segment and a sixth electrode segment, where the fourth electrode segment couples to the fifth electrode segment and the fifth electrode segment couples to the sixth electrode segment. The fourth electrode segment may extend in a direction parallel to the sixth electrode segment, and the second electrode segment may extend in a direction parallel to the fifth electrode segment. The second electrode segment may extend in a direction orthogonal to the first electrode segment.

An example embodiment provides a system including a first electrode with a first electrode segment, a second electrode segment, a third electrode segment, and fourth electrode segment. The first electrode segment may contact the second electrode segment, the second electrode segment may contact the third electrode segment, the third electrode segment may contact the fourth electrode segment. The third electrode segment may extend in a direction parallel to the first electrode segment, and the fourth electrode segment may extend in a direction parallel to the second electrode segment. A second electrode may extend in a direction parallel to the first electrode. An interelectrode dielectric may be between the first electrode and second electrode. An intra-electrode dielectric may be between the first electrode segment and the second electrode segment. A third electrode may extend in a direction orthogonal to the first electrode and the second electrode, with the third electrode coupled to the first electrode. The interelectrode dielectric may include one or more of carbide, nitride, or oxide. The interelectrode dielectric may extend in a direction parallel to the first electrode. The first electrode segment may contact the fourth electrode segment. The material of the interelectrode dielectric may differ from the material of the intra-electrode dielectric. The first electrode segment, the second electrode segment, the third electrode segment and the fourth electrode segment may enclose the intra-electrode dielectric.

An example embodiment provides a method including forming a trench, forming a conductor within the trench to form a mold, forming a first dielectric within the mold, removing at least a portion of the conductor to form one or more dielectric openings, and forming a second dielectric within the one or more dielectric openings. The conductor may be formed based on at least one of chemical vapor deposition, physical vapor deposition, or atomic layer deposition. The material of the first dielectric may differ from the material of the second dielectric. The first dielectric may be formed by at least one of atomic layer deposition and chemical vapor deposition. The first dielectric may include a nitride, and the second dielectric may include an oxide. In some embodiments, prior to forming the second dielectric within the one or more dielectric openings, at least one of the first dielectric and the conductor may be trimmed using a wet-etch process to enlarge the one or more dielectric openings.

### BRIEF DESCRIPTION OF THE DRAWING

In the following section, the aspects of the subject matter disclosed herein will be described with reference to example embodiments illustrated in the figures, in which:
FIG. 1A depicts a cross-sectional view of a semiconductor structure according to various embodiments of the subject matter disclosed herein;
FIG. 1B depicts a plan perspective view of a semiconductor structure according to various embodiments of the subject matter disclosed herein;
FIG. 1C depicts a perspective view of a semiconductor structure according to various embodiments of the subject matter disclosed herein;
FIGS. 2A-2K depict plan views of an example embodiment of a semiconductor structure at different stages of its manufacture;
FIGS. 3A-3I depict cross-sectional views of an example embodiment of a semiconductor structure at different stages of its manufacture;
FIG. 4A-4J depict perspective views of an example embodiment of a semiconductor structure at different stages of its manufacture;
FIG. 5 depicts a plan view of a method forming a semiconductor structure according to various embodiments of the subject matter disclosed herein;
FIGS. 6A-6C depict cross-section views of an example embodiment of a semiconductor structure at different stages of its manufacture;
FIGS. 7A-7D depict cross-section views of an example embodiment of a semiconductor structure at different stages of its manufacture; and
FIG. 8 depicts a plan view of a method forming a semiconductor structure according to various embodiments of the subject matter disclosed herein.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," etc.) may be occasionally interchangeably used with a corresponding non-hyphenated version (e.g., "two dimensional," "predetermined, etc.), and a capitalized entry (e.g., "Counter Clockwise," "Three-Dimensional," etc.) may be interchangeably used with a corresponding non-capitalized version (e.g., "counter clockwise," "three-dimensional," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein substrates may refer to a variety of materials and structures, including wafers using silicon, wafers using silicon on an insulator (SOI) such as glass, wafers of other semiconductor materials such as germanium, as well as other semiconductor materials on an insulator. In some embodiments, a substrate may include an organic material. In some embodiments, the substrates may be referred to as wafers, dies, and chips alone or in combination.

As used herein, memory may refer to various forms of semiconductor memory including both volatile memory where data is lost when power is turned off, and non-volatile memory which may retain data after power is turned off. Examples of volatile memory may include forms of random-access memory such as static random-access memory (SRAM), dynamic random-access memory (DRAM), synchronous dynamic random-access memory (SDRAM), double data rate DRAM or DDR DRAM. Examples of non-volatile memory may include flash memory devices, read only memory (ROM), programmable read only memory (PROM), electronically programmable read only memory (EPROM), electronically erasable and programmable read only memory (EEPROM), phase-change random-access memory (Phase-change RAM), ferroelectric random-access memory (FRAM), and resistive random-access memory (RRAM).

As used herein, three-dimensional memory or 3D memory may refer to any form of memory, including both volatile and non-volatile memory, containing individual elements organized in three-dimensions. For example, multiple planes of memory cells may be stacked upon each other. As used herein, vertically-stacked dynamic random-access memory (VSDRAM) may refer to a three-dimensional structure of DRAM where individual layers of DRAM elements may be stacked upon each other. In some embodiments, 3D memory may be organized that the addressing matrix is orthogonal to the memory cells. That is, in some embodiment, each of the bit line, the word line, and capacitors may extend in a different direction, such that each direction is orthogonal to the other. In some embodiments, the vertical direction, that is the direction orthogonal to the plane of the substrate, may be parallel to the bit line. In some embodiments, the word line or the capacitors may extend in the vertical direction. As used herein, bit line, word line, read line, address line, grid, array, and matrix may be used interchangeably to describe the various electrodes organized to provide a signal where two lines intersect within a larger device.

As used herein, conductors or conductive materials may refer to a variety of conductive materials, including which materials may be used alone or in combination with other materials. In some embodiments the conductor includes a semiconductor material such as, silicon (Si), germanium (Ge), gallium arsenide (GaAs), indium phosphide (InP) or any other suitable material. In some embodiments, the conductor may include a metal such as copper (Cu), tungsten (W), titanium (Ti), either alone or in combination. In some embodiments, the conductor may include a combination of materials, including oxides and nitrides. Such a listing of elements is not intended to be exhaustive, and in other embodiments, any known other type of conductive material may be used.

As used herein, dielectrics or dielectric materials may refer to non-conductive materials, and may include materials such as various semiconductor materials and the carbides, nitride and oxides thereof, such as silicon nitride (Si₃N₄) or silicon dioxide (SiO₂). Such dielectric materials may have a relatively low relative permittivity (εᵣ), such as less than 10 (εᵣ <10), or less than 20 (εᵣ <20), or less than 30 (εᵣ <30), or less than 40 (εᵣ <40), or less than 50 (εᵣ <50), or less than 100 (εᵣ <100), and thus be a poor conductor. In some embodiments, a dielectric material may include a fluidic material. In some embodiments, a dielectric material may take the form of an air gap.

Disclosed herein are various embodiments of devices, systems and methods related to a U-shaped vertical electrode within a 3D memory device. A 3D memory device may have vertically oriented bit lines forming a U-shape, the vertical bit lines formed from a conductor, and the vertical bit lines spaced apart by an isolation interlayer dielectric. The isolation interlayer dielectric may include a first dielectric which may provide isolation between each bit line electrode and a second dielectric which may provide isolation between each end of an individual electrode. The U-shaped electrode structure may thus fill a large space, allowing flexibility in forming connecting electrodes, while simplifying the process to create a vertical electrode. Furthermore, the second dielectric material may reduce the surface area of each electrode, and thus the capacitance between each electrode may be reduced. In some embodiments, the first dielectric may be a liner dielectric, and the second dielectric may be a bulk dielectric. In some embodiments, the isolation interlayer dielectric may be formed primarily of the first dielectric, while in other embodiments, the isolation interlayer dielectric may be formed primarily of the second dielectric.

The isolation interlayer dielectric and U-shaped vertical bit lines may be formed by first forming a trench within a 3D memory device, the trench being orthogonal to the word line and capacitor orientations. Within the trench, one or more dielectric materials, including the first dielectric material, may be deposited to form a substrate isolation layer to provide electrical isolation between the electrode and substrate. Then, a sacrificial dielectric layer may be deposited over the substrate isolation layer to fill the trench. Within the trench, the sacrificial dielectric layer may be etched to form a series of openings extending vertically to form a mold. Within the mold, the conductor may be conformally deposited to cover the exposed surfaces, leaving a rectangular opening in the center. After the conductor is deposited, the second dielectric may be used to fill the rectangular opening of the conductor and create an intra-electrode isolation layer to separate the vertical portions of the conductor. Then, the mold, including the remainder of the sacrificial dielectric may be removed by etching, forming a gap between each conductor. Then, within the gap, a portion of at least a portion of the first dielectric, the second dielectric, and the conductor may be trimmed to form one or more U-shaped vertical electrodes. Additional dielectric material may then be deposited between each of the U-shaped vertical electrodes to form the inter-electrode isolation layer.

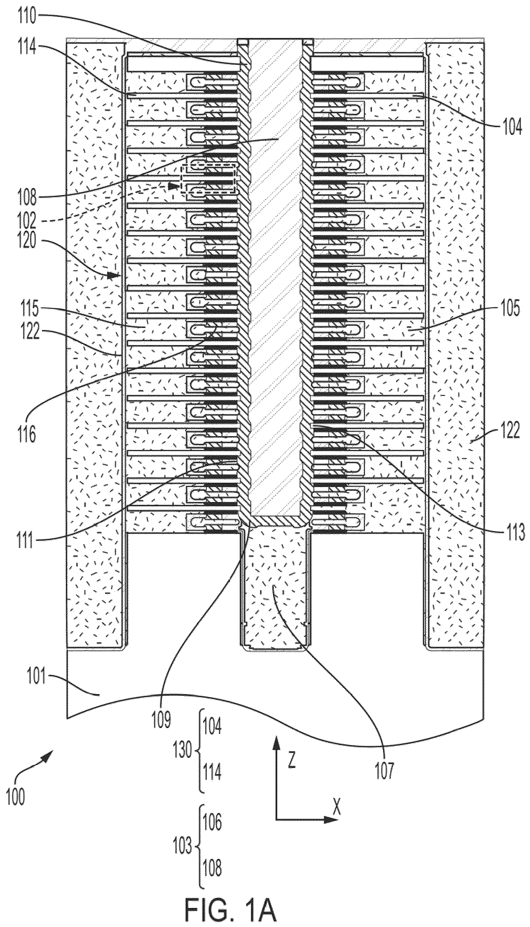

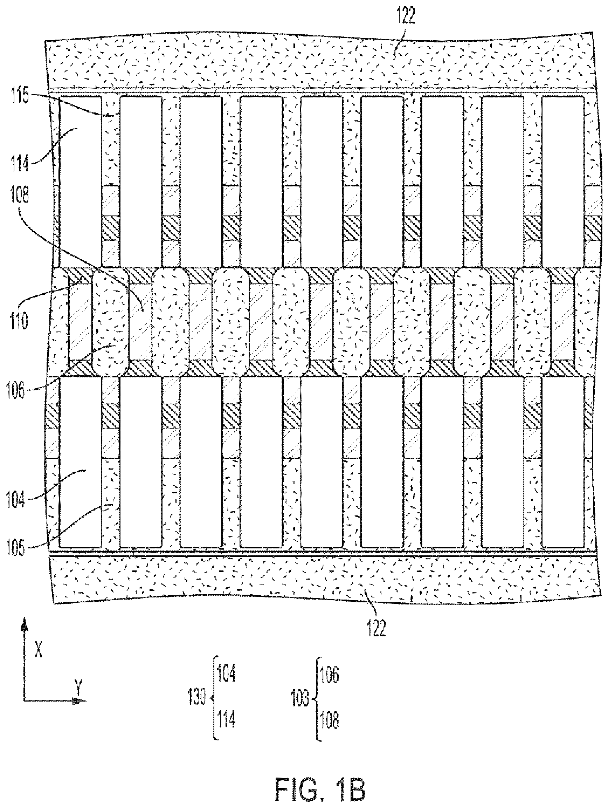

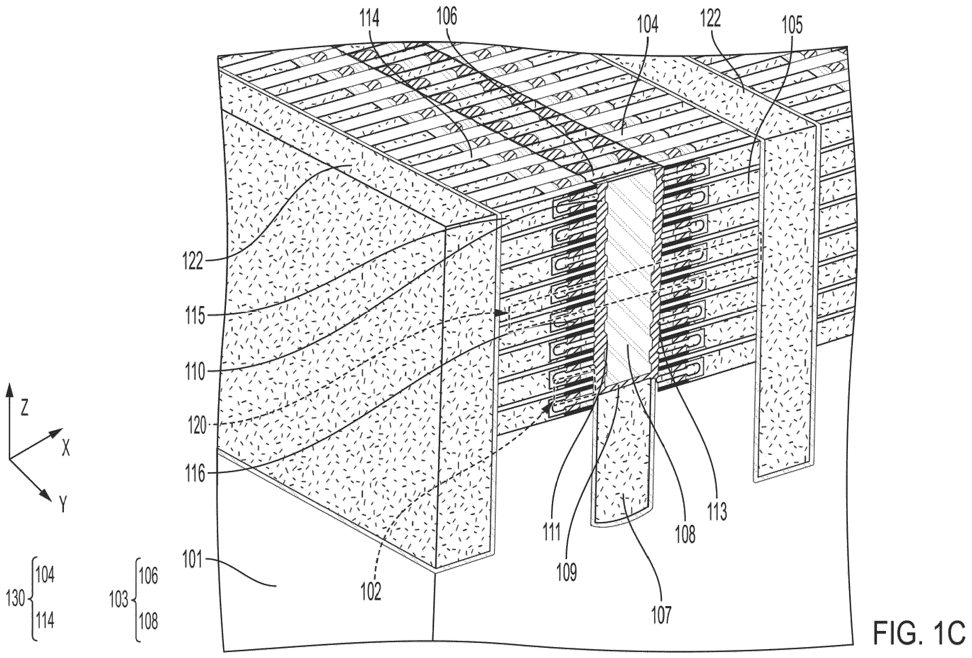

FIG. 1A depicts a cross-sectional view of an example embodiment of a first device architecture 100 in the X and Z directions. FIG. 1B depicts a plan view of the first device architecture 100 in the X and Y directions, while FIG. 1C depicts a perspective view of the first device architecture 100. The first device architecture 100 may form a portion of a 3D memory device, as well as any other suitable three-dimensional semiconductor devices.

In the example of FIG. 1A, the 3D memory device may take the form of a vertically stacked device, where individual device layers 120 may be stacked upon each other. In some embodiments, the individual device layers 120 may take the form of a memory device such as DRAM, with the resulting 3D memory device of the first device architecture 100 taking the form of a vertically stacked DRAM. However, in other embodiments, the form of the individual device layers 120 may vary, and may include one or more layers such as SRAM, SDRAM, or any other suitable memory devices, either alone or in combination. In the example embodiment of FIGS. 1A-1C, the individual device layers 120 may be substantially similar to each other, while in other embodiments, at least two of the individual device layers 120 may differ from each other in terms of the number of devices, the type of devices, and the layout of the devices.

In the first device architecture 100, the addressing of individual elements such as capacitors, memory cells, or other suitable elements, may use of one or more vertical electrodes 110 and one or more horizontal electrodes 116 to provide signals to one or more cell electrodes 130. In the example embodiment of FIGS. 1A-1C, the one or more vertical electrodes 110 extend in the Z-direction, while the one or more horizontal electrodes 116 extend in the Y-direction, and the one or more cell electrodes 130 extend substantially in the X-direction. In some embodiments, the one or more vertical electrodes 110 may be used as the bit line and the one or more horizontal electrodes 116 may be used as the word line. In other embodiments, the one or more vertical electrodes 110 may be used as the word line and the one or more horizontal electrodes 116 may be used as the bit line.

The one or more vertical electrodes 110 may take the form of a U-shaped electrode, the U-shaped electrode including two opposing sections, a first vertical electrode segment 111 and a second vertical electrode segment 113, extending in the Z-direction. At least one of the first vertical electrode segment 111 and the second vertical electrode segment 113 may be coupled with one or more cell electrodes 130 extending in the X-direction. The first vertical electrode segment 111 and the second vertical electrode segment 113 may be connected by the bottom electrode segment 109, which may extend in the X-direction between the first vertical electrode segment 111 and the second vertical electrode segment 113. Between the substrate 101 and the bottom electrode segment 109, a substrate isolation layer 107 may be formed. The substrate isolation layer 107 may be formed from a dielectric material, and may provide electrical isolation between the substrate 101 and the one or more vertical electrodes 110.

As shown in FIGS. 1A-1C, between each of the one or more vertical electrodes 110, an interelectrode isolation layer 103 may be formed. The interelectrode isolation layer 103 may, in some embodiments, include one or more dielectric materials, including a first dielectric material 106 forming the isolation layer between each of the one or more vertical electrodes 110 and a second dielectric material 108 forming the isolation layer between the first vertical electrode segment 111 and the second vertical electrode segment 113 of a single electrode of the one or more vertical electrodes 110. In some embodiments, the dielectric material used to form the first dielectric material 106 and the second dielectric material 108 may include semiconductor materials, as well as nitrides, carbides, and oxides thereof. In some embodiments, the first dielectric material 106 and the second dielectric material 108 may consist of silicon oxide, silicon nitride, or other similar materials such as gallium nitride, gallium oxide, and so forth. In some embodiments, the first dielectric material 106 and the second dielectric material 108 may consist of the same dielectric material, while in other embodiments, the first dielectric material 106 and the second dielectric material 108 may consist of different materials, which may include different etch response rates. In some embodiments, additional dielectric materials such as a third dielectric material or a fourth dielectric material may be formed within the interelectrode isolation layer 103. As such, the one or more vertical electrodes 110 may be separated from each other by the first dielectric material 106, separating the one or more vertical electrodes 110 into a set of interdigitated electrodes. In some embodiments, the first dielectric material 106 may be selected to protect against a short between the one or more vertical electrodes 110. In some embodiments, the first dielectric material 106 may be selected to have a low relative permittivity (εᵣ) to protect against a parasitic capacitance between the one or more vertical electrodes 110.

As the one or more vertical electrodes 110 have the second dielectric material 108 between the first vertical electrode segment 111 and the second vertical electrode segment 113, the cross-sectional area of each of the one or more vertical electrodes 110 in the Z and X directions may be reduced compared to if the one or more vertical electrodes were a solid electrode extending across the entire space of the one or more cell electrodes 130. As capacitance may depend on surface area, the capacitance between each of the one or more vertical electrodes 110 may also be reduced compared to a solid electrode. In addition, the reduction of conductive material and additional dielectric materials may provide better thermal and electrical isolation between each of the one or more vertical electrodes 110, as well as between the one or more vertical electrodes 110 and the substrate 101.

The one or more cell electrodes 130 may be separated by the one or more vertical electrodes 110 into one or more left side cell electrodes 104 and one or more right side cell electrodes 114. The one or more left side cell electrodes 104 and the one or more right side cell electrodes 114 may be made of a suitable material for use in semiconductor devices, for example, a semiconductor material such as silicon or germanium, as well as metals, or any other suitable conductor, alone or in combination. In some embodiments, the one or more left side cell electrodes 104 and the one or more right side cell electrodes 114 may be made of substantially the same material, while in other embodiments the one or more left side cell electrodes 104 and the one or more right side cell electrodes 114 may be made of different materials. In some embodiments, the one or more cell electrodes 130 may form a portion of one or more transistors 102 The one or more transistors 102 may receive the source side current from the one or more vertical electrodes 110, with a gate current being provided by the one or more horizontal electrodes 116. A drain side electrode may be coupled to the one or more transistors 102 to provide a drain current in the drain region 122. The presence of a gate current on the one or more horizontal electrodes 116 may thus induce a field effect within one of the one or more cell electrodes 130, enabling current to flow between the source side and drain side. The one or more transistors 102 may be combined with a capacitor in the drain region 122 to form an individual memory cell.

In some embodiments, one or more isolation layers may be provided between each of the one or more cell electrodes 130. In some embodiments, one or more left side isolation layers 105 may be arranged between each of the one or more left side cell electrodes 104. Similarly, in some embodiments, one or more right side isolation layers 115 may be arranged between each of the one or more right side cell electrodes 114. In some embodiments, an isolation layer, like the one or more left side isolation layers 105 or the one or more right side isolation layers 115, may be made of a dielectric material and may include semiconductor materials, as well as nitrides, carbides, and oxides thereof. In some embodiments, the one or more left side isolation layers 105 or the one or more right side isolation layers 115 may consist of silicon oxide, silicon nitride, or other similar materials such as gallium nitride, gallium oxide, as well as combinations thereof. In some embodiments, the one or more left side isolation layers 105 or the one or more right side isolation layers 115 may consist of the same dielectric material, while in other embodiments, the one or more left side isolation layers 105 or the one or more right side isolation layers 115 may consist of different materials. In some embodiments, at least one of the one or more left side isolation layers 105 or the one or more right side isolation layers 115 may be formed of substantially the same materials as one or more of the first dielectric material 106 and the second dielectric material 108, while in other embodiments, the materials of the one or more left side isolation layers 105 or the one or more right side isolation layers 115 may differ from the first dielectric material 106 and the second dielectric material 108.

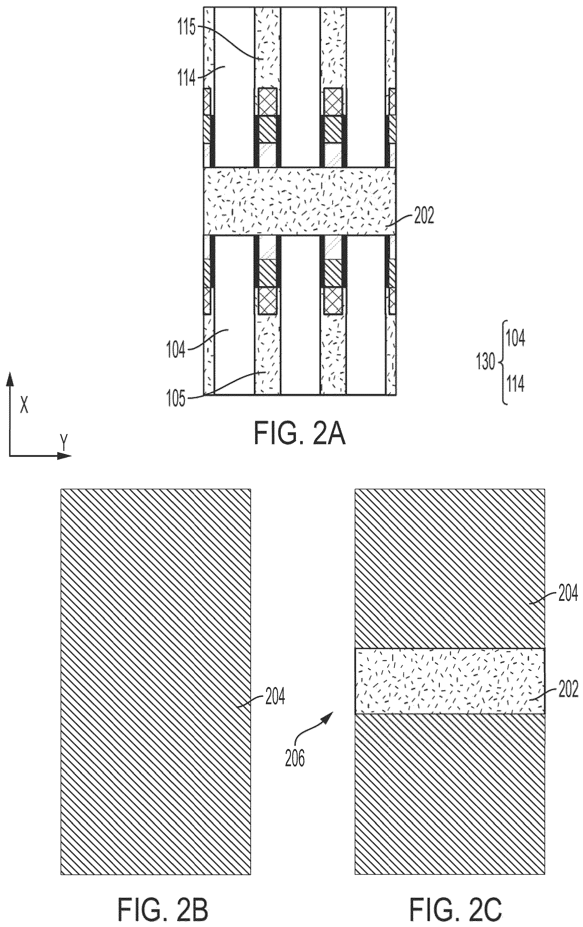

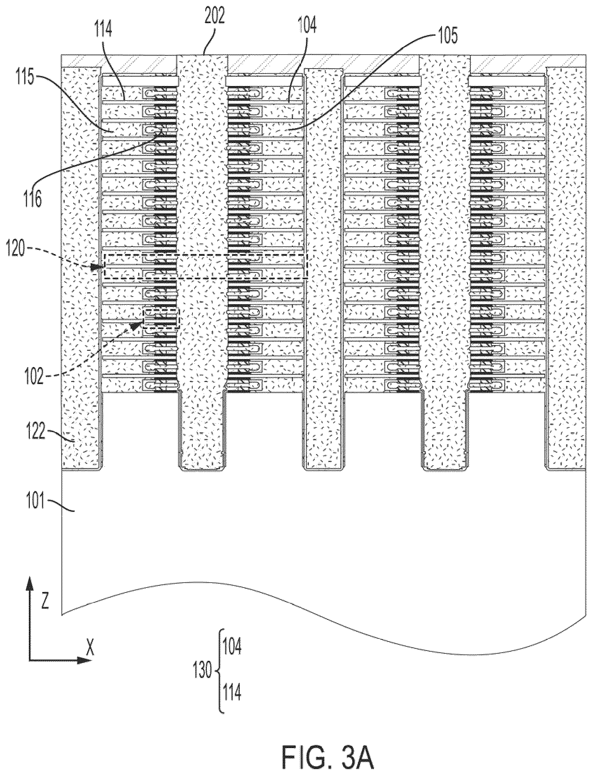

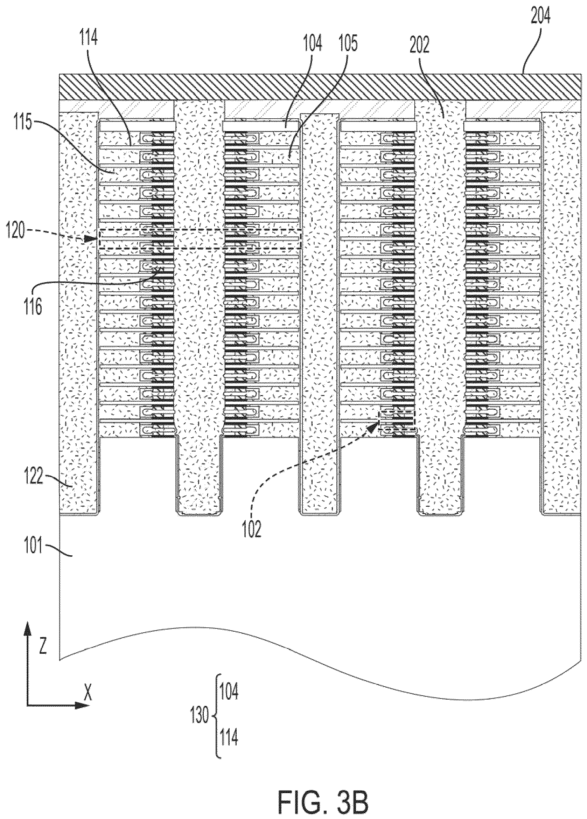

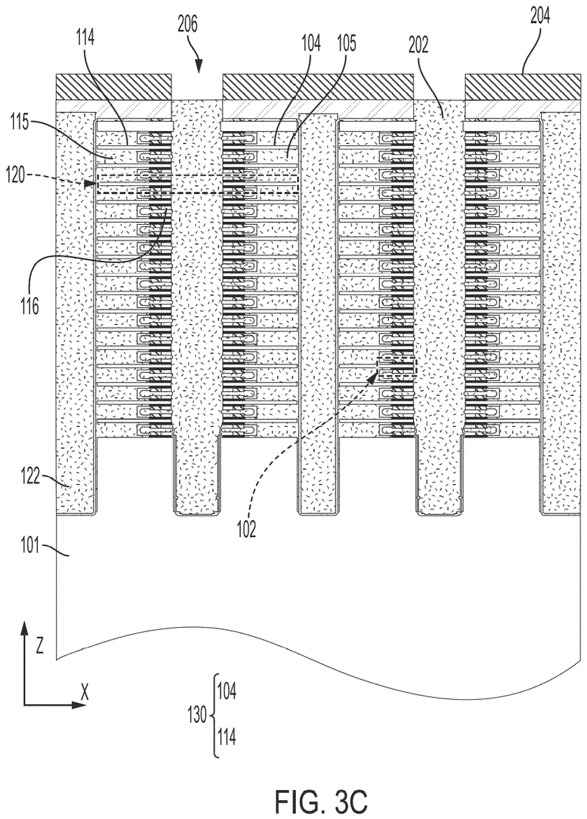

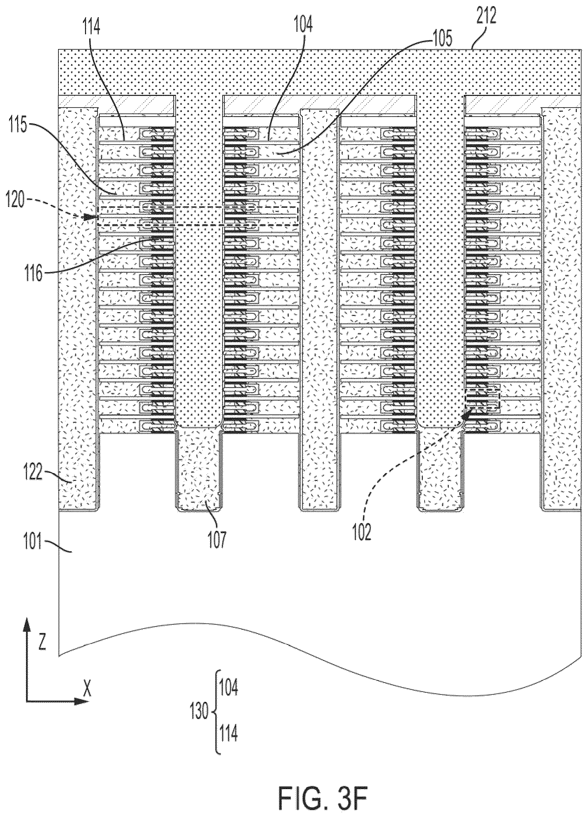

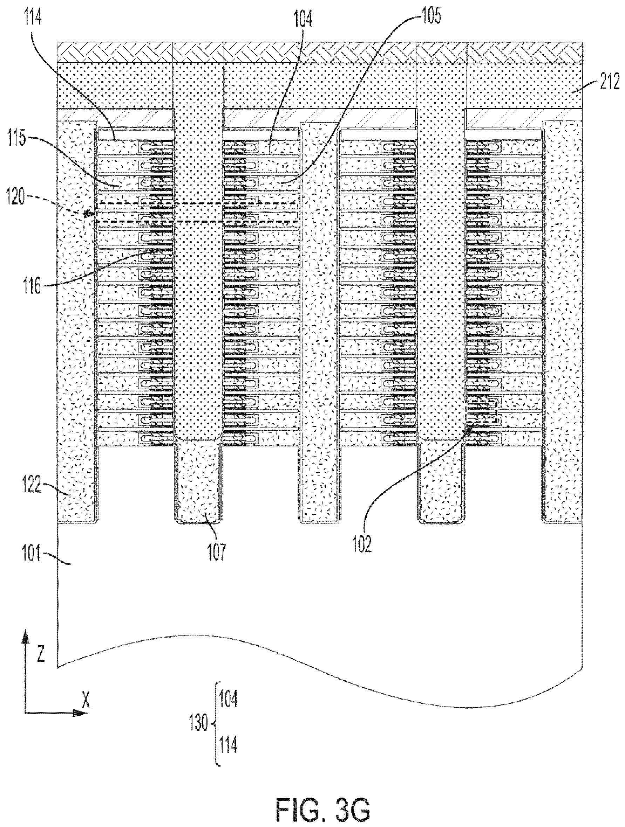

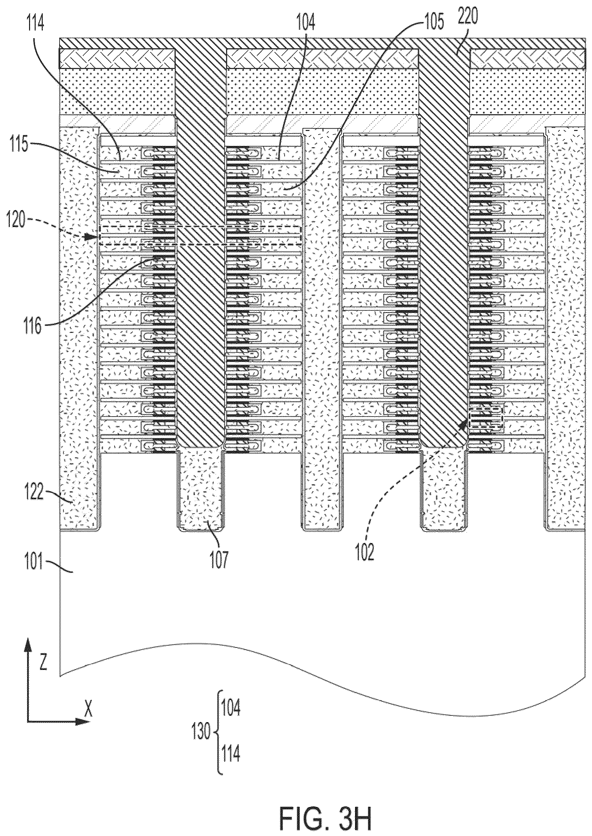

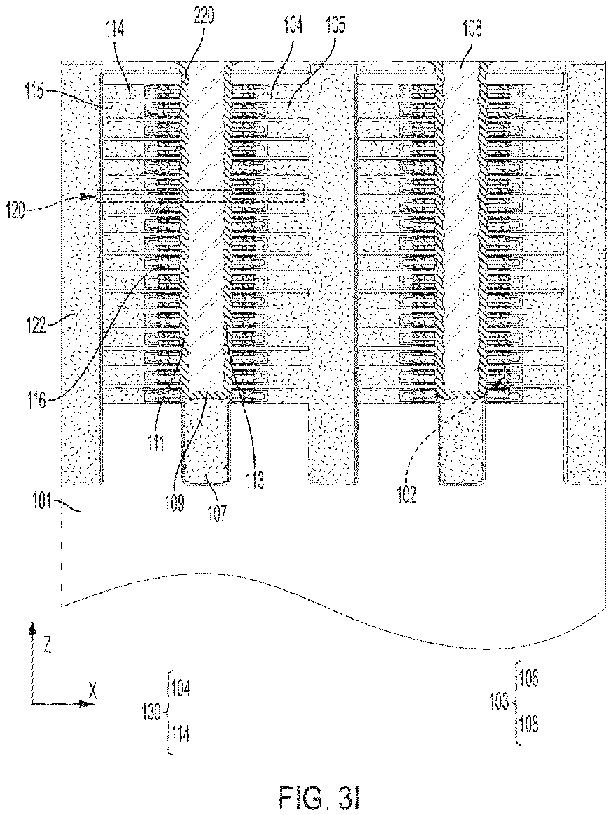

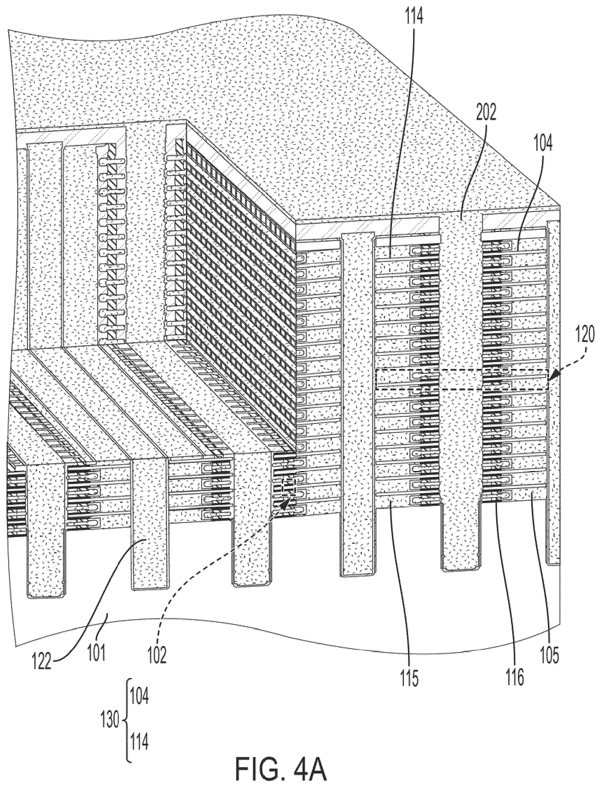

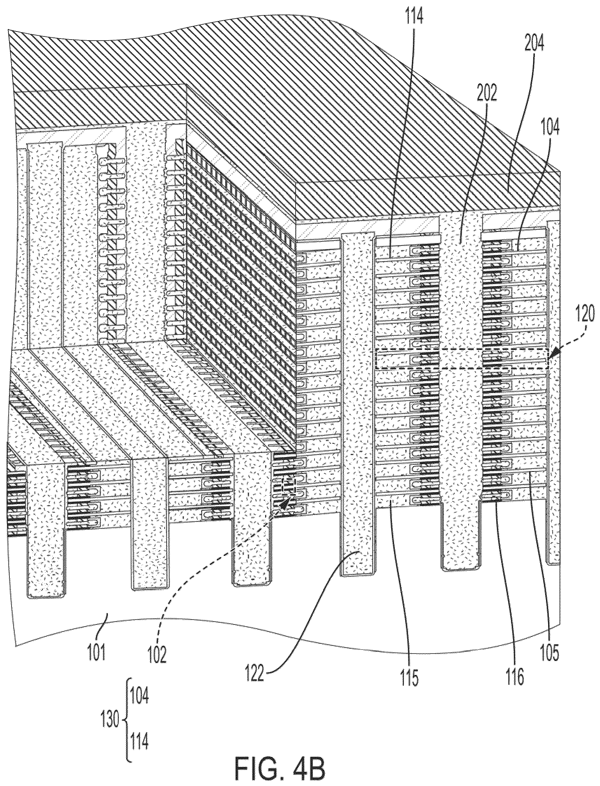

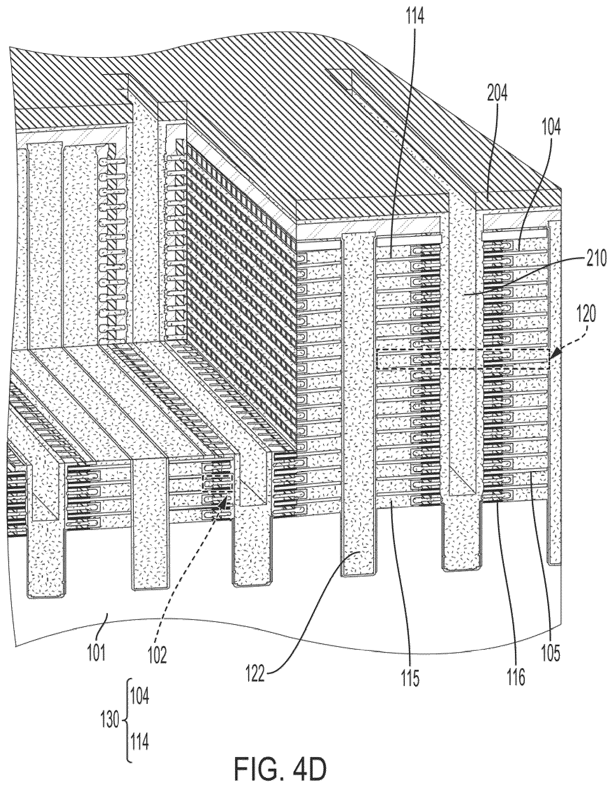

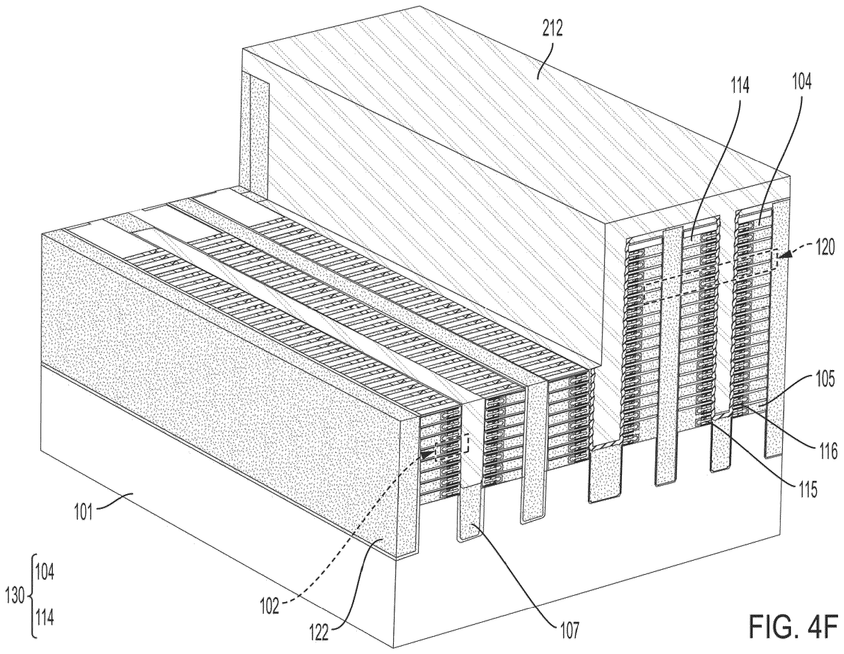

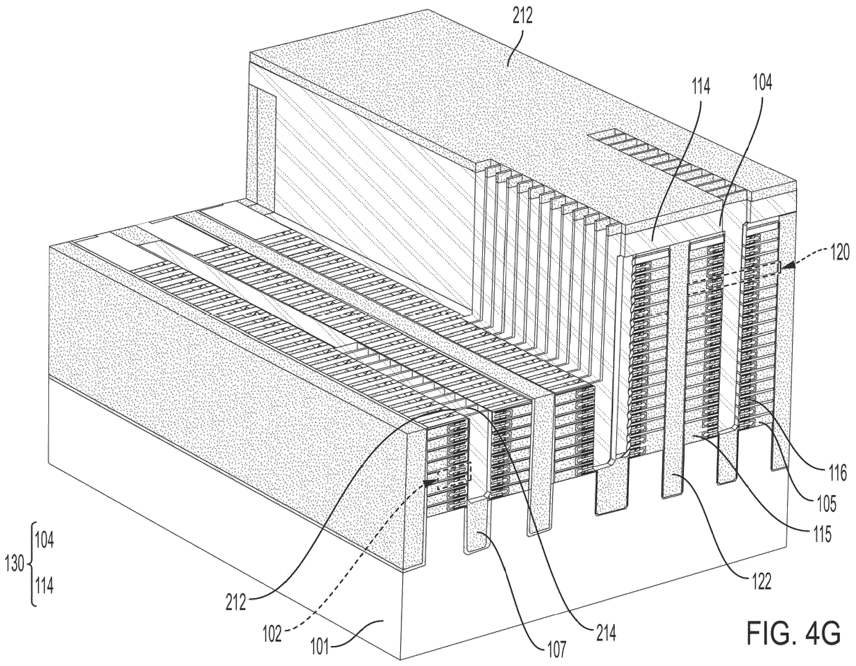

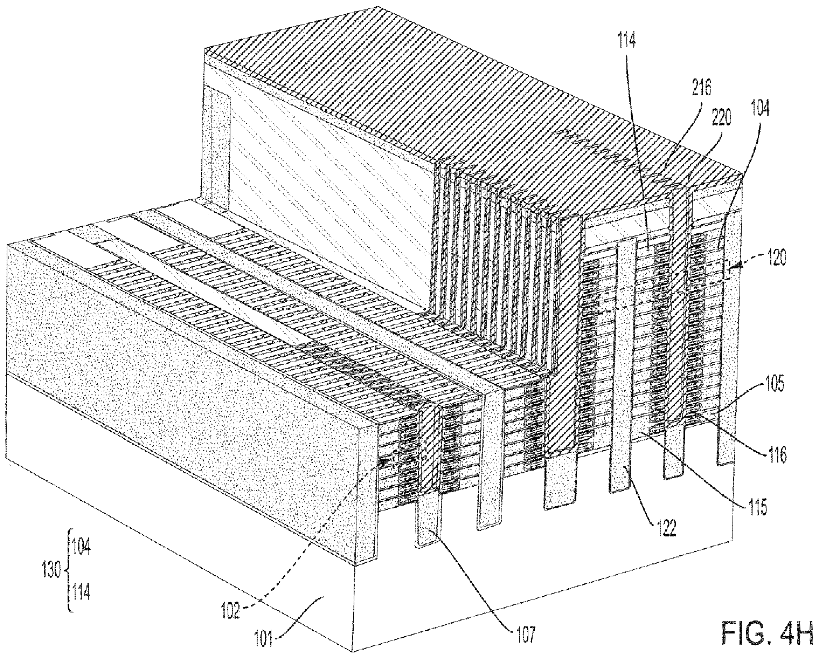

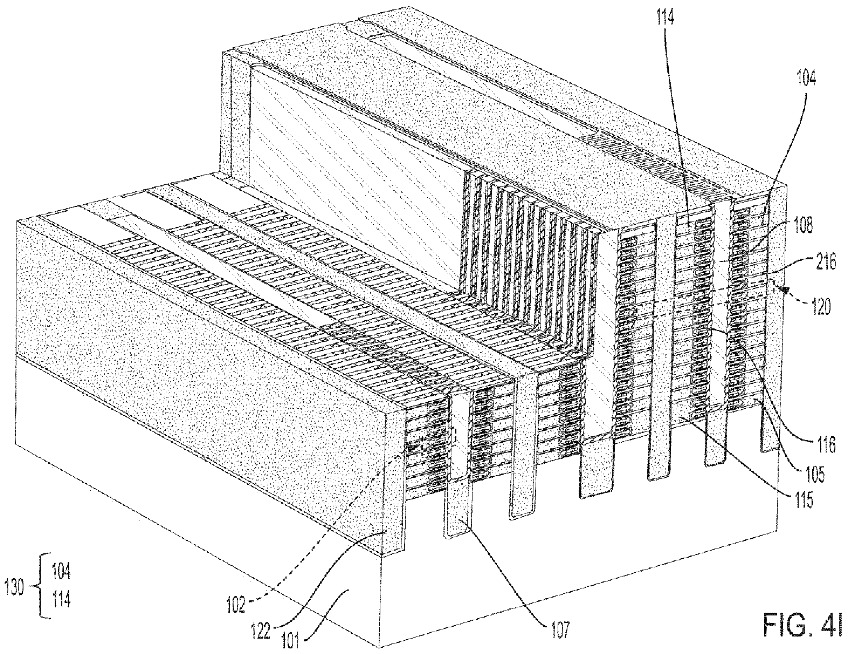

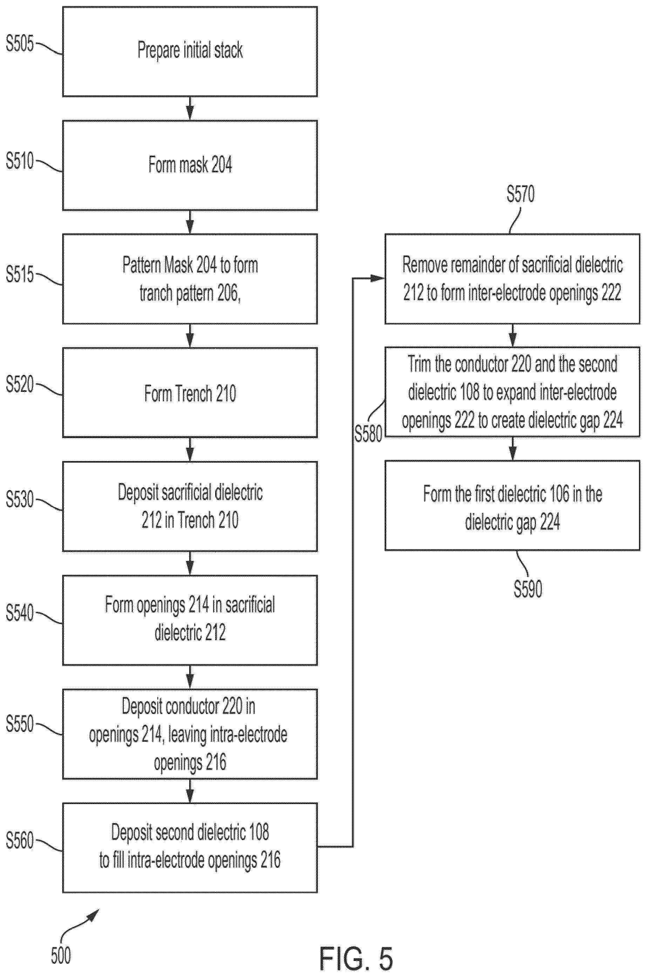

FIGS. 2A-2K depict an illustrative embodiment of a process of forming a device architecture such as the first device architecture 100, or any other device architectures shown herein in a plan view. FIGS. 3A-3I and FIGS. 4A-4J depict corresponding cross-sectional views and perspective views of the process. FIG. 5 depicts an example embodiment of a process 400 for forming a device architecture corresponding to the illustrative embodiment of FIGS. 2A-2K, FIGS. 3A-3I, and FIGS. 4A-4J.

FIG. 2A, FIG. 3A and FIG. 4A depict S505 in the process of FIG. 5, where an initial stack is prepared prior to forming a trench. The individual device layers 120 may be initially formed with the one or more left side cell electrodes 104 and one or more right side cell electrodes 114 formed as part of the one or more transistors 102. The one or more left side cell electrodes 104 and one or more right side cell electrodes 114 may be formed of a semiconductor material such as silicon or germanium, and may be formed using a suitable process such as chemical vapor deposition (CVD), physical vapor deposition (PVD), and/or atomic layer deposition (ALD). In some embodiments, the one or more left side cell electrodes 104 and one or more right side cell electrodes 114 may be formed using an epitaxial process. The one or more left side isolation layers 105 and the one or more right side isolation layers 115 may be formed between each of the one or more left side cell electrodes 104 and one or more right side cell electrodes 114. The one or more left side isolation layers 105 and the one or more right side isolation layers 115 may be formed of a dielectric material, and formed using a suitable process such as CVD, PVD, and/or ALD. In some embodiments, the one or more left side isolation layers 105 and the one or more right side isolation layers 115 may be formed by a selective removal process, such as etching, to remove portions of the semiconductor material used to form the cell electrodes, and then followed by a deposition process. The one or more horizontal electrodes 116 may be similarly formed by a selective removal process, such as etching, followed by a suitable process, such as CVD, PVD, and/or ALD to form a conductive material. Furthermore, a dielectric material may be deposited between the one or more left side cell electrodes 104 and one or more right side cell electrodes 114 to form a central pillar 202. The central pillar 202 may be formed using a first dielectric material similar to those used in the one or more left side isolation layers 105 and the one or more right side isolation layers 115. In some embodiments, the central pillar 202 may be formed as part of the formation of the one or more left side isolation layers 105 and the one or more right side isolation layers 115, while in other embodiments the central pillar 202 may be formed separately.

FIG. 2B, FIG. 3B and FIG. 4B depict S510 in the process of FIG. 5, where a mask 204 may be formed on the top of the device. The mask 204 may be any suitable material, such as a dielectric material like a nitride, carbide, or oxide, as well as a photoresist. The material of the mask 204 may be chosen such that a selective removal process, such as an etch process, may not affect the material of the mask 204, while the central pillar 202 may be selectively removed.

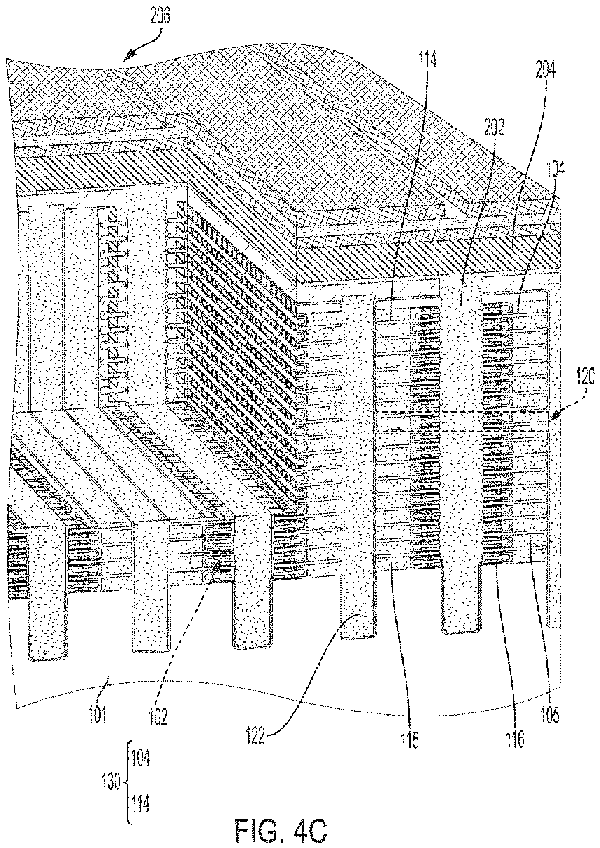

FIG. 2C, FIG. 3C and FIG. 4C- FIG. 4D depict S515 in the process of FIG. 5, where the mask 204 may be patterned to produce the mask pattern 206. In some embodiments, the mask pattern 206 may be formed, for example, by use of etch process, such as wet-etch processes using chemicals and dry-etch processes using reactive plasma, as well as any other suitable method of removal. In some embodiments, such as demonstrated in FIG. 4C, the mask pattern 206 may formed used in combination with a masking step, such as a photoresist mask formed using a lithographic process for selectively covering portions of the first device architecture 100, as well as any other suitable method for patterning the mask 204.

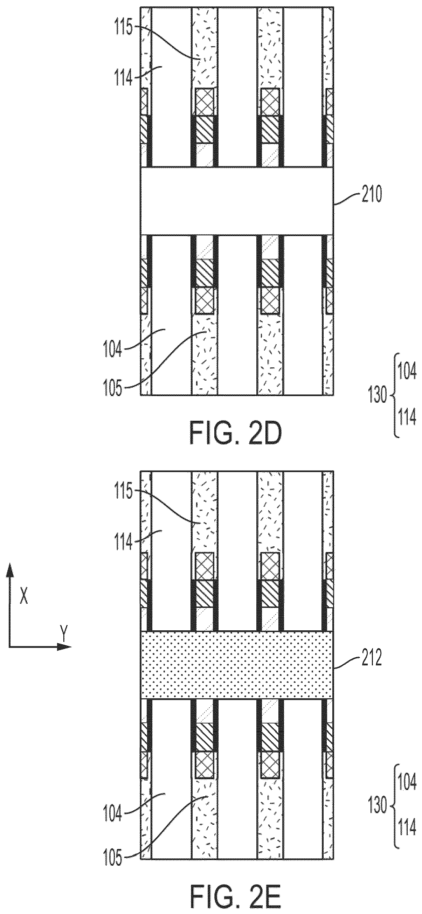

FIG. 2D, FIG. 3D, FIG. 3E and FIG. 4E depict S520 in the process of FIG. 5, where a trench 210 may be formed within the first device architecture 100; the trench 210 separates the one or more cell electrodes 130 into the one or more left side cell electrodes 104 and the one or more right side cell electrodes 114. The trench 210 may be formed using any suitable semiconductor process, and may include techniques such as etching, including both wet-etch processes using chemicals and dry-etch processes using reactive plasma, as well as lithography, mechanical drilling or cutting, lasers, and a combination of these methods and any other suitable methods known in the art. The trench 210 may have a width between the one or more left side cell electrodes 104 and the one or more right side cell electrodes 114 of approximately 150 nm but may vary in other embodiments to a width of between 1 nm and 10 microns, as appropriate. In the embodiment of FIG. 2A, the trench 210 is depicted as extending between the one or more left side cell electrodes 104 and the one or more right side cell electrodes 114, and may include a lateral recessing into the spaces between each of the one or more left side cell electrodes 104, each of the one or more right side cell electrodes 114, or both. However, in some embodiments the trench 210 may not extend laterally beyond the one or more left side cell electrodes 104 or the one or more right side cell electrodes 114, and may form a planar surface.

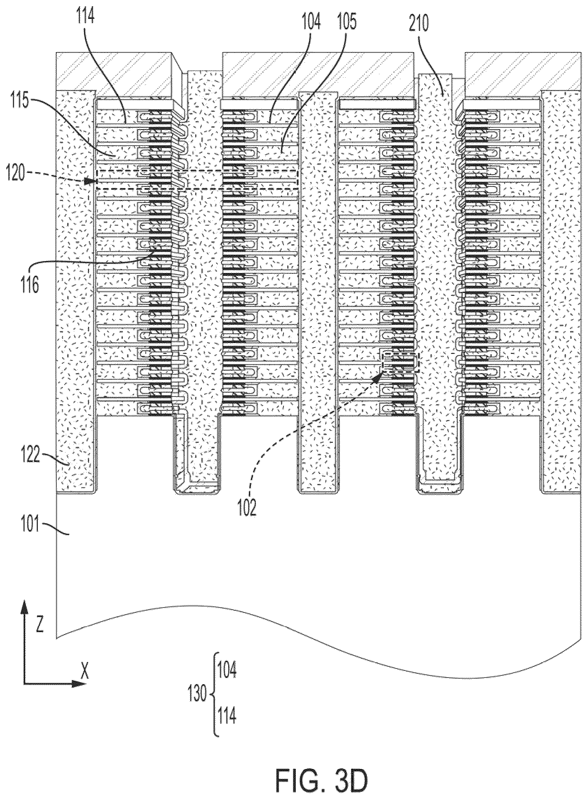

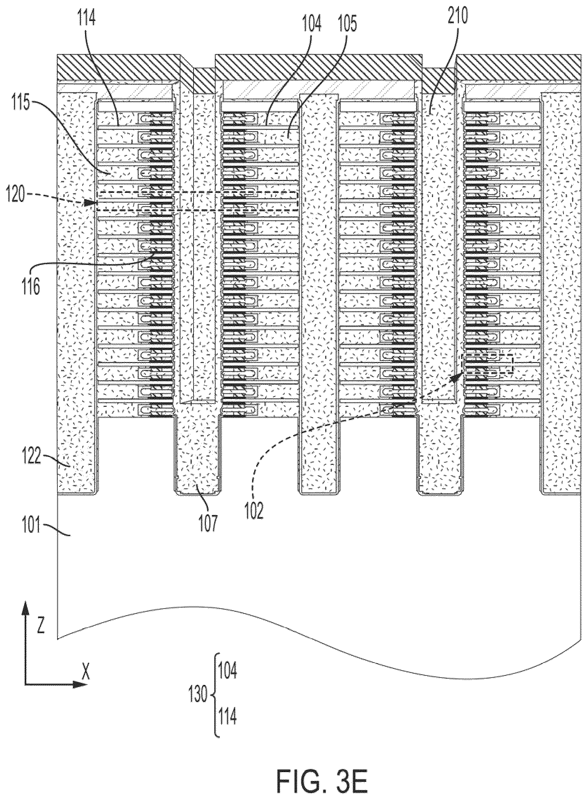

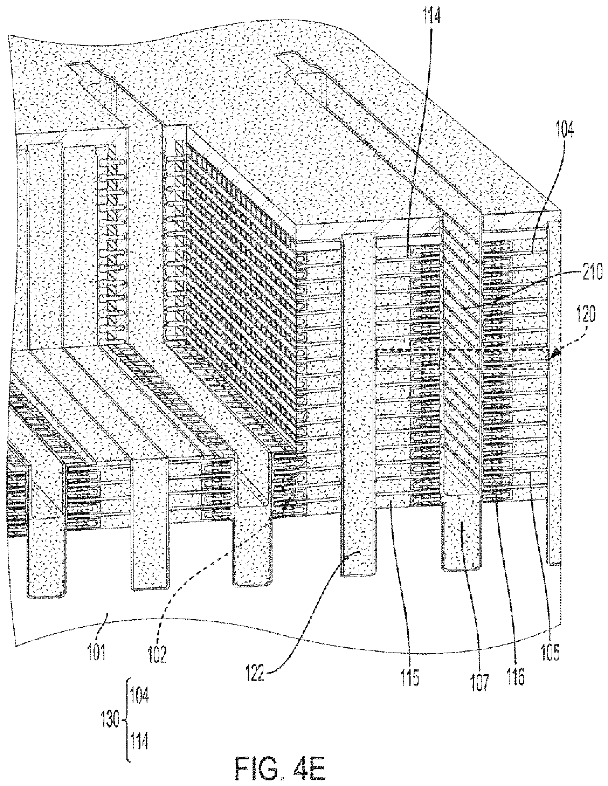

In some embodiments, as shown by FIG. 3D, the trench 210 may be extended to surface of the substrate 101. The substrate isolation layer 107 may then be formed by depositing an appropriate dielectric material, such as a nitride, oxide, or carbide material into the trench 210, as depicted in FIG. 3E. In some embodiments, such as in FIG. 4E, the trench 210 may be formed such that a portion of the central pillar 202 may be left behind to form the substrate isolation layer 107.

After the trench 210 and the substrate isolation layer 107 are formed, any remaining portions of the mask 204 may be removed. For example, in some embodiments, a planarization process such as a chemical-mechanical polish (CMP) may be used to remove remaining portions of the mask 204, while other processes such as etching may be used alone or in combination with a planarization process.

FIG. 2E, FIG. 3F and FIG. 4F depict S530 in the process of FIG. 5, where a sacrificial dielectric 212 may be deposited within the trench 210 and over the substrate isolation layer 107. The sacrificial dielectric 212 may be deposited using a process such as CVD, ALD, or any other suitable method to fill the remainder of the trench 210. The sacrificial dielectric 212 may, in some embodiments, be chosen for ease of removal, and, for example, may consist of a carbon-based dielectric material, such as a carbide.

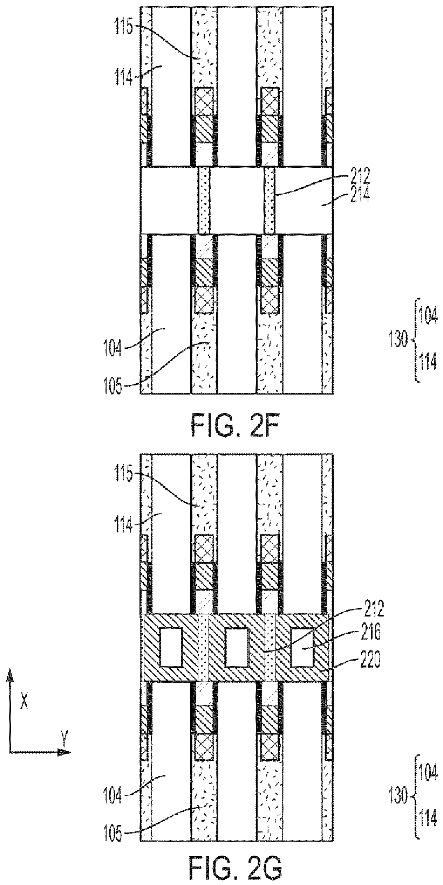

FIG. 2F, FIG. 3G, and FIG. 4G. depict S540 in the process of FIG. 5 where openings 214 may be formed within the sacrificial dielectric 212. The openings 214 may be formed, for example, by use of etch process, such as wet-etch processes using chemicals and dry-etch processes using reactive plasma, as well as any other suitable method of removal. In some embodiments, the etch process may be used in combination with a masking step, such as a photoresist mask formed using a lithographic process for selectively covering portions of the first device architecture 100, as well as any other suitable method for patterning the sacrificial dielectric 212. In some embodiments, a dry-etch may be suitable for removal of the sacrificial dielectric 212 when the sacrificial dielectric 212 may be formed of a carbon material. The relative size of the openings 214 in the X-Y dimension may be large, with the openings extending between two of the one or more cell electrodes 130, and extending along the trench 210 beyond either of the one or more left side isolation layers 105 and the one or more right side isolation layers 115. The large relative size in the X-Y dimension of the openings 214 may thus provide a larger critical dimension for additional steps than otherwise defined by the spacing between each of the one or more cell electrodes 130, and may allow a smaller aspect ratio in the interelectrode isolation layer 103 than defined by the spacing between each of the one or more cell electrodes 130.

FIG. 2G, FIG. 3H, and FIG. 4H. depict S550 in the process of FIG. 5, where a conductive material 220 may be deposited within the openings 214, which will be used to form the one or more vertical electrodes 110. The conductive material 220 may include doped semiconductor materials, metals such as tungsten, functionalized carbon nanomaterials, as well as any other suitable conductive material. In some embodiments, the conductive material of the one or more vertical electrodes 110 may be formed by a semiconductor process such as CVD, ALD, PVD, electroplating, or any other suitable method for forming a conductive material. In some embodiments, the openings 214 in the sacrificial dielectric 212 may operate as a mold to shape the conductive material 220. In some embodiments, the conductive material 220 may be formed using a conformal process, such that the conductive material 220 may be formed over the exposed surfaces of the openings 214, including the sacrificial dielectric 212, as well as the surfaces of the trench 210, including the one or more cell electrodes 130 and the one or more left side isolation layers 105 and the one or more right side isolation layers 115. The conductive material 220 thus may be coupled with the one or more cell electrodes 130, and have a U-shaped cross-section. The remaining portions of the openings 214 may be referred to as the intra-electrode openings 216

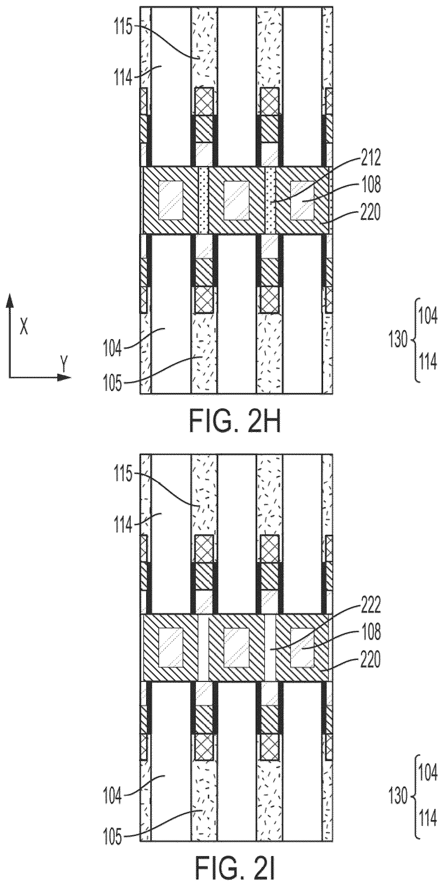

FIG. 2H, FIG. 3I, and FIG. 4I depict S560 in the process of FIG. 5, where the second dielectric material 108 may be deposited within the intra-electrode openings 216. In some embodiments, the intra-electrode openings 216 in conductive material 220 may operate as a mold to shape the second dielectric material 108. The second dielectric material 108 may be formed using a conformal process such as ALD, as well as any other suitable process. The second dielectric material 108 may form a coating over the exposed surfaces of the intra-electrode openings 216. In some embodiments, the second dielectric material 108 may include semiconductor materials, as well as nitrides, carbides, and oxides thereof, such as silicon, silicon carbide, silicon nitride, and silicon dioxide, as well as any other suitable materials such as an air gap, ceramic materials, and polymer materials with a high dielectric constant. In some embodiments, a conformal deposition of the second dielectric material 108 may leave a portion of the intra-electrode openings 216 still open for additional deposition, while in other embodiments, the intra-electrode openings 216 may be fully filled by the second dielectric material 108.

FIG. 2I depicts S570 in the process of FIG. 5, where the remainder of the sacrificial dielectric 212 may be removed. The remainder of the sacrificial dielectric 212 may be removed by any suitable process, including etch processes, such as wet-etch processes using chemicals and dry-etch processes using reactive plasma, as well as any other suitable method of removal. The openings formed by the removal of the remainder of the sacrificial dielectric 212 may be referred to as inter-electrode openings 222.

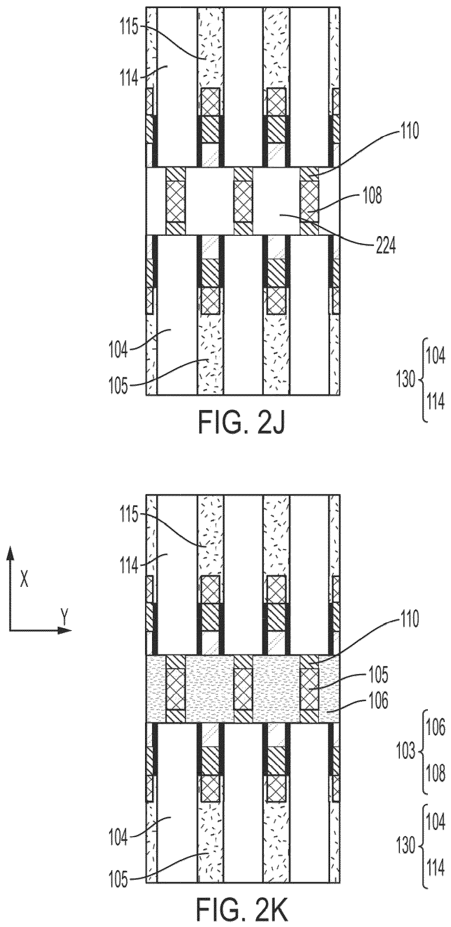

FIG. 2J depicts S580 in the process of FIG. 5, where the conductive material 220 and the second dielectric material 108 may be trimmed down to size while the inter-electrode openings 222 may be expanded to match the size of the one or more cell electrodes 130 to form dielectric openings 224. The conductive material 220 and the second dielectric material 108 may be trimmed by any suitable process, including etch processes, such as wet-etch processes using chemicals and dry-etch processes using reactive plasma, as well as any other suitable method of removal. In some embodiments, the materials forming the conductive material 220 and the second dielectric material 108 may differ such that an etchant effective against the second dielectric material 108 may be ineffective against the conductive material 220, such that the boundary between the conductive material 220 and the second dielectric material 108 acts as an etch stop. In some embodiments, the boundary between the conductive material 220 and the second dielectric material 108 may be a self-aligned etch stop. In other embodiments, one or more masking and patterning steps may be included to define a mask for use in etching.

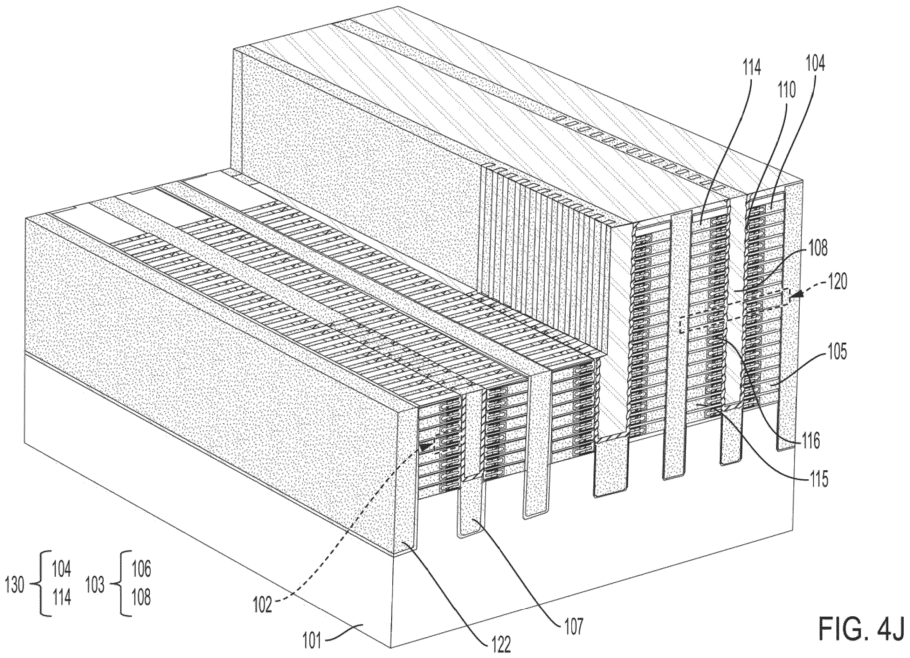

FIG. 2K and FIG. 4J depict S590 in the process of FIG. 5 where, after the inter-electrode openings 222 are expanded to form the dielectric openings 224, the first dielectric material 106 may be deposited within the dielectric openings 224. The first dielectric material 106 may include semiconductor materials, as well as nitrides, oxides, and carbides thereof, including silicon nitride, silicon oxide, and any other suitable dielectric. In some embodiments, the first dielectric material 106 may be formed by a semiconductor process such as CVD, ALD, PVD or any other suitable method. In some embodiments, excess material may be removed via a planarization process such as CMP.

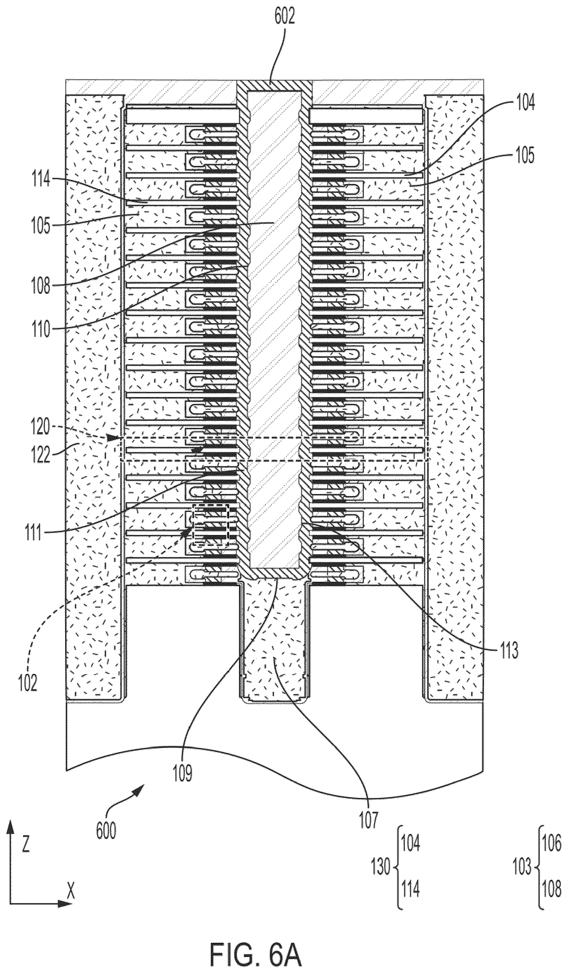

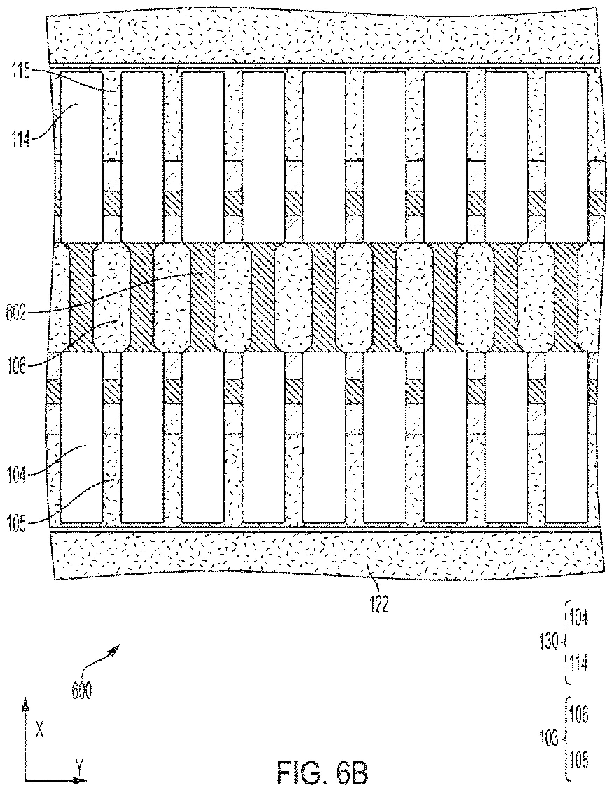

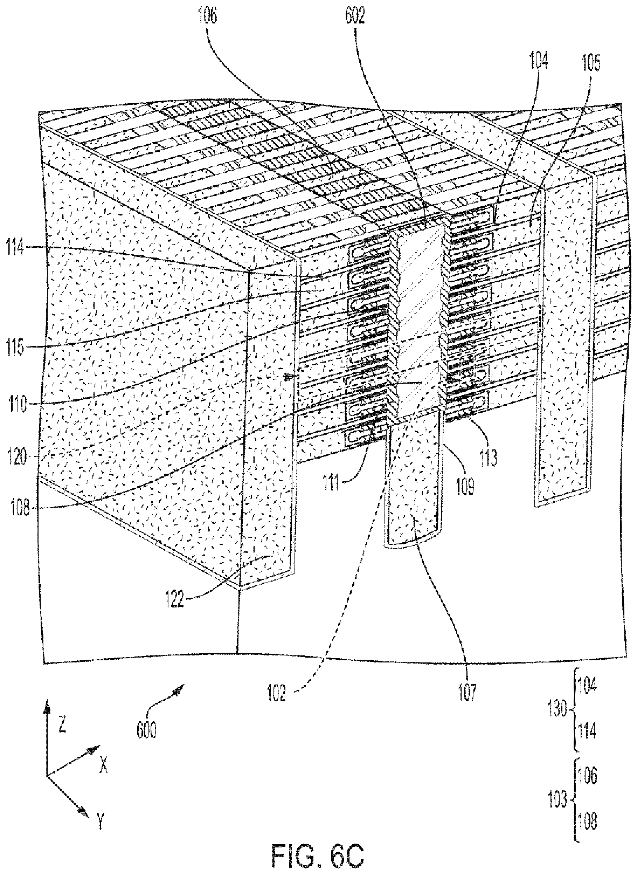

FIG. 6A depicts an illustrative embodiment of a second device architecture 600 in a cross-sectional view along the X-direction and Z-direction. FIG. 6B depicts a plan view in the X-direction and Y-direction of the second device architecture 600, and FIG. 6C depicts a perspective view of the second device architecture 600. The second device architecture 600 of FIGS. 6A-6C differs from the first device architecture by including a top electrode segment 602 in addition to the first vertical electrode segment 111, the second vertical electrode segment 113 and the bottom electrode segment 109. The top electrode segment 602 may be formed parallel to the direction of the substrate 101, and parallel to the bottom electrode segment 109. The top electrode segment 602 may be formed to provide a conductive plug, providing a larger contact area for the one or more vertical electrodes 110 to couple with additional electrodes.

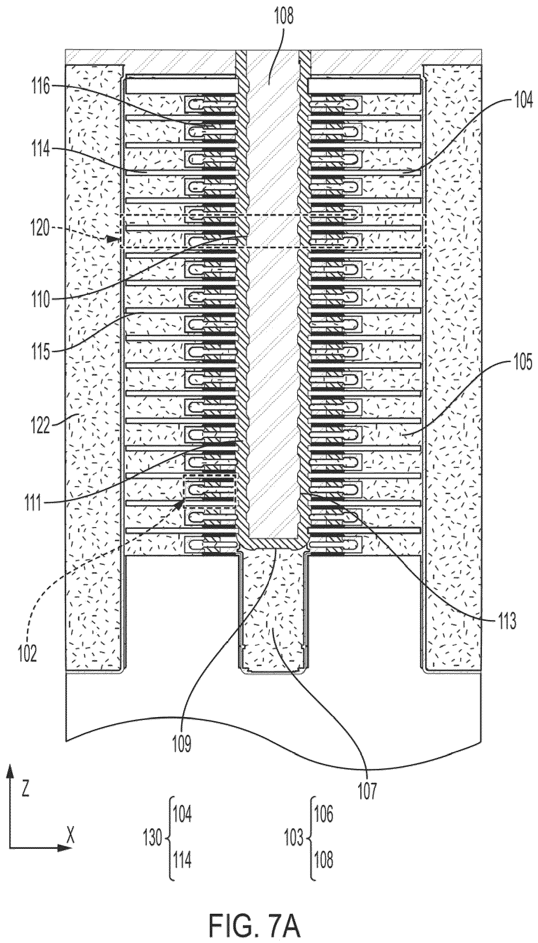

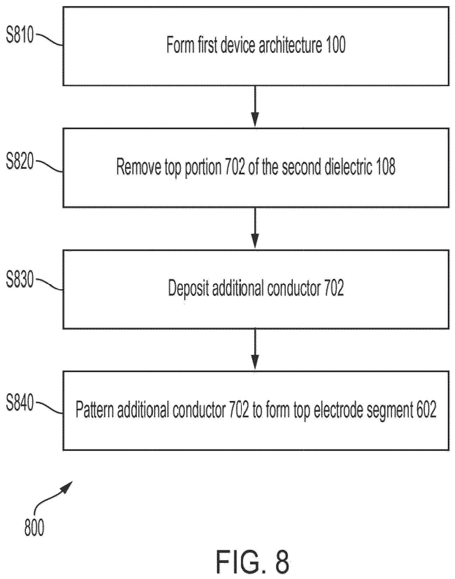

FIG. 7A-7D depict an illustrative embodiment of a process of forming a device architecture such as the second device architecture 600. FIG. 8 depicts an example embodiment of a process 800 for forming a device architecture corresponding to the illustrative embodiment of FIGS. 7A-7D.

FIG. 7A depicts S810 in the process of FIG. 8, where the first device architecture 100 is formed. The process to form the first device architecture 100 may be the same as discussed above with respect to process 500, and as detailed in FIGS. 2A-2K, FIGS. 3A-3I, and FIGS. 4A-4J.

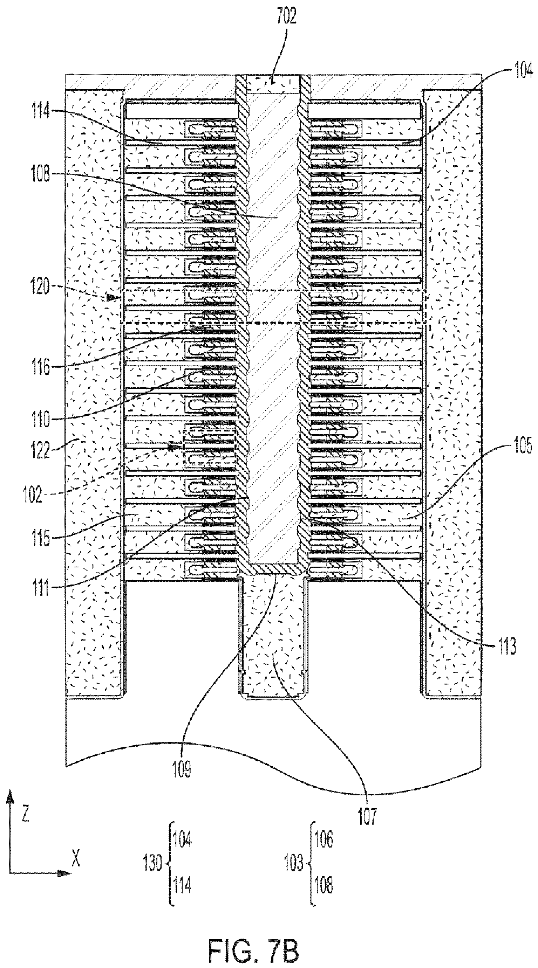

FIG. 7B depicts S820 in the process of FIG. 8, where a top portion 702 of the second dielectric material 108 may be removed. The removal of the top portion 702 of the second dielectric material 108 may be performed using a method such as an etch process, including wet etch, dry etch, as well as any other suitable method in the art. The removal of the top portion 702 of the second dielectric material 108 may remove sufficient amounts of the second dielectric material 108 such that the one or more vertical electrodes 110 may be exposed.

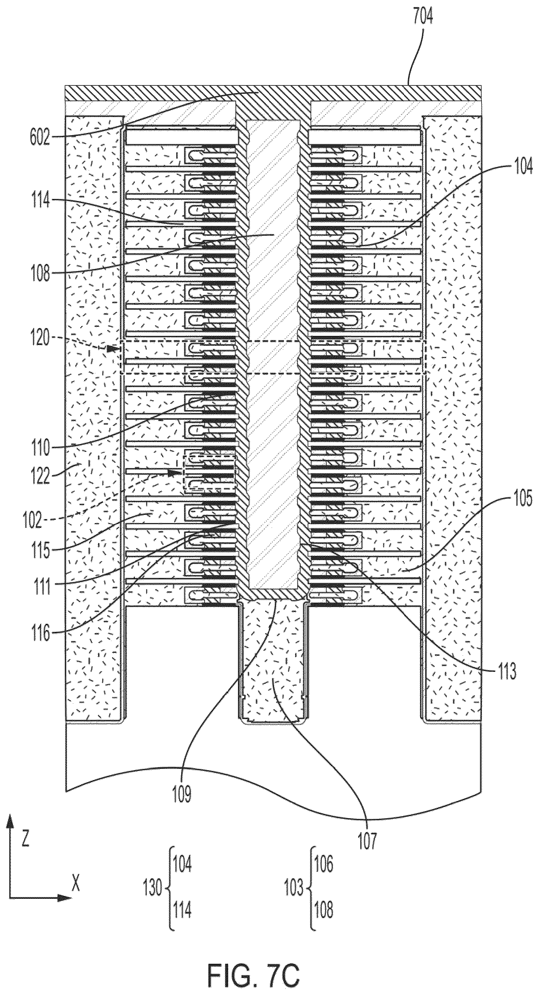

FIG. 7C depicts S830 in the process of FIG. 8, where an additional conductor 704 may be deposited as a layer over the device including the exposed portion of the second dielectric material 108. The additional conductor 704 may be the same material used in the one or more vertical electrodes 110. The additional conductor 704 may be deposited using any suitable technique, including PVD, CVD, ALD and electroplating. The additional conductor 704 may be formed using a different technique than the conductor used to form the one or more vertical electrodes 110, as the step coverage to replace the top portion 702 of the second dielectric material 108 is less than that of the trench 210.

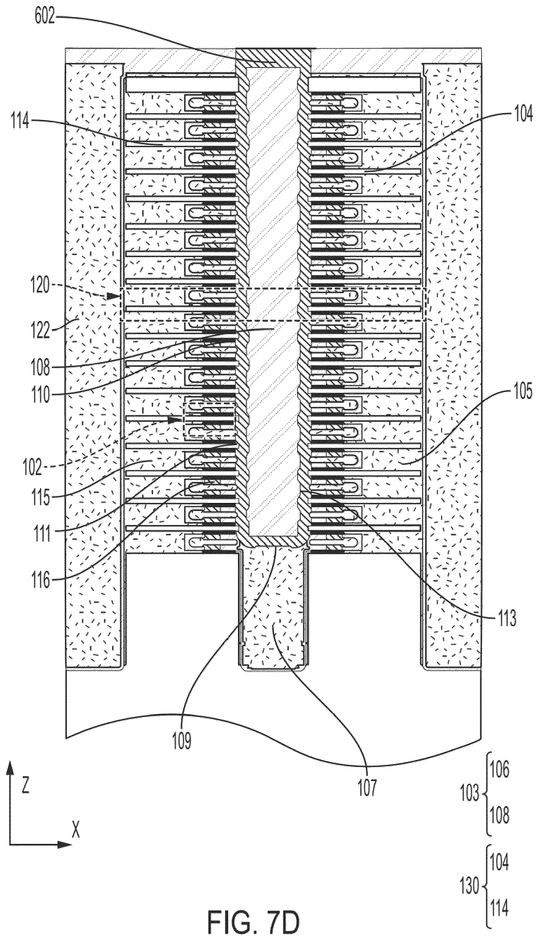

FIG. 7D depicts S840 in the process of FIG. 8, where the additional conductor 704 may be patterned to form the top electrode segment 602. The patterning may be any appropriate process, such as wet etch or dry etch, and may incorporate one or more additional masking processes. For example, a photolithography process may be used to define a mask to cover the top electrode segment 602, while the remaining surface of the additional conductor 704 may be removed using a process such as etch.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

## Claims

1. A device comprising:
a first electrode (104) comprising a first electrode segment (111), a second electrode segment (109), and a third electrode segment (113), wherein the first electrode segment (111) coupled to the second electrode segment (109), the second electrode segment (109) coupled to the third electrode segment (113);
a second electrode (114) extending in a direction parallel to the first electrode (104);
a first dielectric material (106) arranged between the first electrode (104) and the second electrode (114);
a second dielectric material (108) arranged between the first electrode segment (111) and the third electrode segment (113); and
a third electrode (116) contacting the first electrode (104), the third electrode (116) extending in a direction orthogonal to the first electrode (104),
wherein the first electrode segment (111) extends in a direction parallel to the third electrode segment (113).

2. The device of claim 1, wherein:
the first dielectric material (106) comprises one or more of carbide, nitride or oxide, and
the second dielectric material (108) comprises one or more of carbide, nitride or oxide.

3. The device of claim 1 or 2, wherein the first dielectric material (106) differs from the second dielectric material (108).

4. The device of any one of the previous claims, wherein:
the first electrode (104) comprises a vertical bit line electrode, and
the third electrode (116) comprises a cell electrode.

5. The device of any one of the previous claims, wherein:
the first dielectric material (106) extends in a direction parallel to the first electrode (104), and
the second dielectric material (108) extends in a direction parallel to the first electrode (104).

6. The device of any one of the previous claims, wherein:
the second electrode (114) further comprises a fourth electrode segment (111) of the second electrode (114), a fifth electrode segment (109) of the second electrode (114), and a sixth electrode segment (116) of the second electrode (114),
the fourth electrode segment (111) of the second electrode (114) is coupled to the fifth electrode segment (109) of the second electrode (114), the fifth electrode segment (109) of the second electrode (114) coupled to the sixth electrode segment (116) of the second electrode (114),
the fourth electrode segment (111) of the second electrode (114) extends in a direction parallel to the sixth electrode segment (116) of the second electrode (114), and
the second electrode segment (109) of the second electrode (114) extends in a direction parallel to the fifth electrode segment (109) of the second electrode (114).

7. The device of claim 1, wherein the second electrode segment (109) extends in a direction orthogonal to the first electrode segment (111).

8. The device of any one of the previous claims, wherein:
the first electrode (104) comprises a fourth electrode segment (602) of the first electrode (104),
the first electrode segment (111) contacts the second electrode segment (109),
the second electrode segment (109) contacts the third electrode segment (113),
the third electrode segment (113) contacts the fourth electrode segment (602) of the first electrode (104),
the fourth electrode segment (602) of the first electrode (104) extends in a direction parallel to the second electrode segment (109),
an interelectrode dielectric comprising the first dielectric material (106) and arranged between the first electrode (104) and the second electrode (114);
an intra-electrode dielectric comprising the second dielectric material (108) and arranged between the first electrode segment (111) and the second electrode segment (109); and
the third electrode (116) extends in a direction orthogonal to the second electrode (114).

9. The device of claim 8, wherein the interelectrode dielectric extends in a direction parallel to the first electrode (104).

10. The device of claim 8 or 9, wherein the first electrode segment (111) contacts the fourth electrode segment (602) of the first electrode (104).

11. The device of any one of claims 8 to 10, wherein a material of the interelectrode dielectric is different from a material of the intra-electrode dielectric.

12. The device of any one of claims 8 to 11, wherein the first electrode segment (111), the second electrode segment (109), the third electrode segment (113) and the fourth electrode segment (602) of the first electrode (104) form an enclosure around the intra-electrode dielectric.

13. A method comprising:
forming (S520) a trench (210);
forming a conductor (220) within the trench (210) to form a mold (216);
forming a second dielectric (108) within the mold (216);
removing at least a portion of the conductor (220) to form one or more dielectric openings (222); and
forming a first dielectric (106) within the one or more dielectric openings (222).

14. The method of claim 13, further comprising, after forming the first dielectric (106) within the one or more dielectric openings (224), depositing a top conductor (602) over the conductor (220) and the second dielectric (108).

15. The method of claim 13 or 14, further comprising, prior to forming the first dielectric (106) within the one or more dielectric openings (222), trimming at least one of the second dielectric (108) and the conductor (220) using a wet-etch process to enlarge the one or more dielectric openings (222).
